**Europäisches Patentamt**

**European Patent Office**

**Office européen des brevets**

(19)

(11) Veröffentlichungsnummer: **0 299 541 B1**

(12) **EUROPÄISCHE PATENTSCHRIFT**

(45) Veröffentlichungstag der Patentschrift:
**08.05.91 Patentblatt 91/19**

(51) Int. Cl.⁵: **F16P 3/00, B24C 7/00**

(21) Anmeldenummer: **88113579.2**

(22) Anmeldetag: **16.11.87**

(54) **Sicherheitseinrichtung für ein von einer Bedienungsperson zu handhabendes Gerät.**

(30) Priorität: **20.11.86 DE 3639628**
**17.12.86 DE 3643060**

(43) Veröffentlichungstag der Anmeldung:
**18.01.89 Patentblatt 89/03**

(61) Veröffentlichungsnummer der früheren
Anmeldung nach Art. 76 EPü: **0268244**

(45) Bekanntmachung des Hinweises auf die
Patenterteilung:
**08.05.91 Patentblatt 91/19**

(84) Benannte Vertragsstaaten:
**AT BE CH DE ES FR GB GR IT LI LU NL SE**

(56) Entgegenhaltungen:
**DE-A- 3 025 895**
**DE-U- 8 024 045**
**DE-U- 8 526 106**
**DE-U- 8 611 018**
**DE-U- 8 613 771**
**DE-U- 8 631 049**
**DE-U- 8 633 717**
**FR-A- 2 341 806**

(73) Patentinhaber: **Ernst Peiniger GmbH**
**Unternehmen für Bautenschutz**
**Am Funkturm 2**
**W-4300 Essen 1 (DE)**

(72) Erfinder: **Genuit, Klaus, Dr.-Ing-**
**Wildbacher Mühle 77**
**W-5100 Aachen (DE)**
Erfinder: **Cardinal, Joachim**
**Hebborner Kirchweg 101**
**W-5060 Bergisch-Gladbach 2 (DE)**
Erfinder: **Glaeser, Karl Christian**
**Am Arenzberg 24**
**W-5090 Leverkusen 3 (DE)**
Erfinder: **Tilmans, Heinz**
**Repinghofener Strasse 8**
**W-5093 Burscheid (DE)**
Erfinder: **Buhr, Gerhard**
**Karl.-Jaspers-Strasse 101**
**W-5090 Leverkusen 3 (DE)**
Erfinder: **Lohmüller, Detlef, Dipl.-Ing.**
**Rilke-Strasse 90**
**W-5300 Bonn 3 (DE)**

(74) Vertreter: **von Rohr, Hans Wilhelm, Dipl.-Phys.**
**et al**
**Patentanwälte Gesthuysen & von Rohr**
**Huyssenallee 15 Postfach 10 13 33**
**W-4300 Essen 1 (DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft eine Sicherheitseinrichtung nach dem Oberbegriff von Anspruch 1.

Bei einer aus der Praxis und druckshriftlich bekannten Sicherheitseinrichtung für ein von einer Bedienungsperson zu handhabendes Gerät (DE-U 86 13 771), die insbesondere für ein Strahlgerät einer Strahlanlage bestimmt und geeignet ist, bei der das von der Bedienungsperson zu handhabende Gerät über eine Versorgungsleitung für ein Versorgungsmittel, dort Druckluft, an eine Versorgungsmittelquelle angeschlossen ist, ist für eine kürzestmögliche Abschaltung des Gerätes eine Entlastungseinrichtung für die Versorgungsleitung vorgesehen. Diese Entlastungseinrichtung ist an einer vom Gerät entfernten Stelle der Versorgungsleitung nahe dem Anschluß der Versorgungsleitung an der Versorgungsmittelquelle angeordnet und weist einen Entlastungsquerschnitt auf, der ungefähr mit dem Strömungsquerschnitt der Versorgungsleitung übereinstimmt. Der Entlastungseinrichtung ist dabei eine Absperreinrichtung für die Versorgungsleitung zugeordnet. Beide Einrichtungen sind schaltungstechnisch gegeneinander verriegelt.

Die rückwärtige Entlastung der Versorgungsleitung, die aus Sicherheitsgründen wesentlich ist, ist zwar in ihrer Wirkung gut, konstruktiv und verschleißtechnisch aber aufwendig, insbesondere bei Verwendung stark abrasiven Strahlmittels in einer Strahlmittelleitung. Die bei diesem Stand der Technik verwendeten Absperreinrichtungen wie Klappen oder Kugelhahnventile sind insoweit nicht zufriedenstellend.

Bekannt ist eine Sicherheitseinrichtung für eine Strahlanlage, die zwar eine Absperreinrichtung für die Versorgungsleitung, nicht aber eine Entlastungseinrichtung aufweist. Die Absperreinrichtung weist dabei ein kastenartiges, mit Ausnehmungen zur Aufnahme der Versorgungsleitung versehenes Gehäuse auf, in dem ein bewegbares Quetschelement angeordnet ist. Die Versorgungsleitung ist im Bereich der Absperreinrichtung zusammenquetschbar und zwischen dem bewegbaren Quetschelement und einem an der Innenseite des Gehäuses angeordneten feststehenden Quetschelement hindurchgeführt. Das bewegbare Quetschelement ist eine Quetschrolle, die an einem Abtriebs-Kurbelarm eines Antriebs angebracht ist. Wollte man diese Konstruktion bei einer Sicherheitseinrichtung mit Entlastungseinrichtung und Absperreinrichtung einsetzen, so müßte man zwei Antriebe mit Abtriebskurbelarm und Quetschrolle einsetzen, was einen erheblichen technischen Aufwand und hohe Kosten verursachen würde (DE-U 8 024 045).

Der Erfindung liegt die Aufgabe zugrunde, die eingangs erläuterte, bekannte Sicherheitseinrichtung mit einer Entlastungseinrichtung für die Versorgungsleitung und mit einer Absperreinrichtung für die Versorgungsleitung auf technisch-konstruktiv einfache Weise, also möglichst kostengünstig, so auszugestalten, daß im Ansprechfall eine optimale Abschaltung und rückwärtige Entlastung der Versorgungsleitung erfolgen kann.

Die zuvor aufgezeigte Aufgabe ist bei einer Sicherheitseinrichtung mit den Merkmalen des Oberbegriffs von Anspruch 1 durch die Merkmale des kennzeichnenden Teils von Anspruch 1 gelöst. Erfindungsgemäß wird sowohl im Bereich der Entlastungseinrichtung als auch im Bereich der Absperreinrichtung mit einem bewegbaren Quetschelement gearbeitet, dessen Antrieb aber deshalb besonders einfach ist, weil dafür ein Balgzylinder eingesetzt wird. Ohne wesentlichen konstruktiven Aufwand kann man damit eine optimale Abschaltung und rückwärtige Entlastung der Versorgungsleitung realisieren, bei einer Länge von 400 m kann eine solche Versorgungsleitung beispielsweise innerhalb weniger Sekunden entlastet werden.

Es gibt nun viele Möglichkeiten, die erfindungsgemäße Sicherheitseinrichtung in zweckmäßiger Weise auszugestalten und weiterzubilden. Das wird in Verbindungg mit der nachfolgenden Erläuterung eines bevorzugten Ausführungsbeispiels einer mit einer erfindungsgemäßen Sicherheitseinrichtung ausgestatteten Strahlanlage anhand der Zeichnung erläutert. In der Zeichnung zeigt

Fig. 1 in schematischer Darstellung ein Ausführungsbeispiel einer Strahlanlage zum Druckluftstrahlen,

Fig. 2 ein Detail der Strahlanlage aus Fig. 1, beispielhaft und in vergrößerter Darstellung,

Fig. 3 in einer anderen Ausführungsform ein Detail ähnlich Fig. 2 und

Fig. 4 den in Fig. 3 dargestellten Bereich der Strahlanlage aus Fig. 1 in verschiedenen Funktionszuständen.

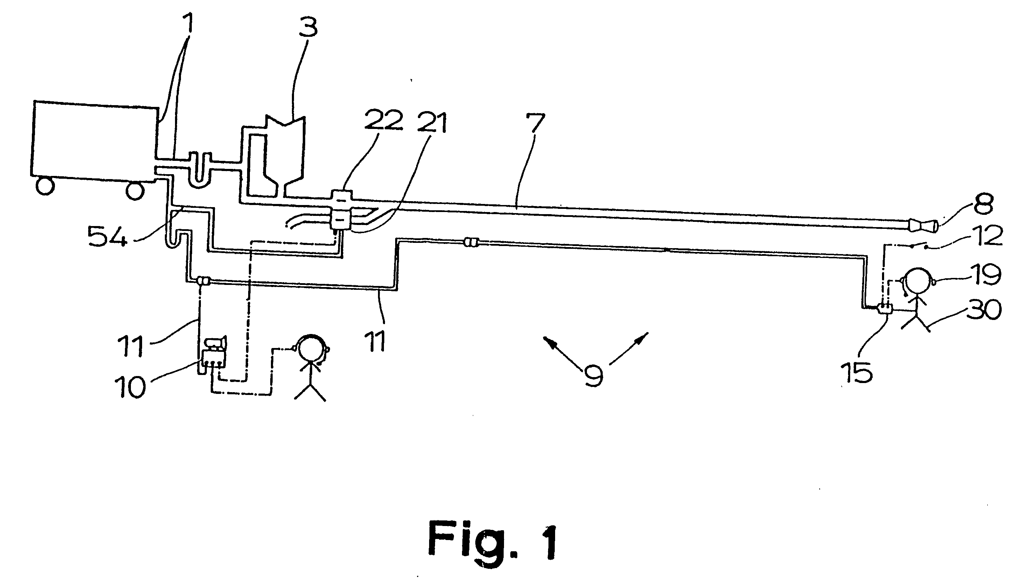

Vorauszuschicken ist, daß anstelle der in Fig. 1 dargestellten Strahlanlage zum Druckluftstrahlen auch andere Anlagen stehen könnten, beispielsweise eine Schaumlöschanlage usw., wie eingangs der vorliegenden Beschreibung angesprochen. Die in Fig. 1 dargestellte Strahlanlage zeigt eine Druckluftleitung 1, die an eine Versorgungsmittelquelle 3, hier in der Form eines üblichen Strahlmittelvorratsbehälters, angeschlossen ist. Von einer Anschlußeinrichtung des Strahlmittelvorratsbehälters 3 aus führt eine Versorgungsleitung 7 zu einem Gerät 8, das von einer Bedienungsperson 30 zu handhaben ist. Im hier dargestellten Ausführungsbeispiel handelt es sich bei der Versorgungsleitung 7 um eine Druckluft/Strahlmittelleitung und beim Gerät 8 um ein Strahlgerät bzw. eine Strahldüse.

Die in Fig. 1 dargestellte Strahlanlage ist mit einer Sicherheitseinrichtung 9 für das von einer Bedienungsperson zu handhabende Gerät 8 ausgestattet, die eine Steuereinrichtung 10 zur Steuerung der Funktion des Geräts 8 und einen am Gerät 8 zugeordneten, von einer Bedienungsperson zu beeinflussenden, mit der Steuereinrichtung 10 über ein Kabel 11 verbundenen Betätigungssensor 12 aufweist. Bei Wegfall der Beeinflussung des Betätigungssensors 12 durch die Bedienungsperson 30 ist das Gerät 8 abschaltbar.

In Fig. 1 ist noch angedeutet, daß neben dem Betätigungssensor 12 eine Normalbetätigungseinheit 15 für eine Fernbedienung des Geräts 8 vorgesehen ist. Eine solche Normalbetätigungseinheit 15 dient der normalen Betätigung des Geräts 8, wohingegen der Betätigungssensor 12 eher der Notfallbetätigung, insbesondere im Rahmen einer Totmannschaltung dient. Eine Normalbetätigungseinheit 15 kann beispielsweise normale Betätigungselemente für die Funktionen Strahlmittel auf/zu, Druckluft auf/zu, Zusatzstoff auf/zu usw. aufweisen.

Fig. 1 läßt weiter noch erkennen, daß das Gerät 8 einen von einer Hand der Bedienungsperson 30 zu erfassenden oder umfassenden Handgriff aufweist und daß hier eine Wechselsprecheinrichtung 19 vorgesehen ist. Die Normalbetätigungseinheit 15 am Gürtel der Bedienungsperson 30 dient gleichzeitig als lokale Steuerzentrale unter Einschluß der Wechselsprecheinrichtung 19.

Schließlich ist in Fig. 1 andeutungsweise gezeigt, daß hier an einer vom Gerät 8 entfernten Stelle der Versorgungsleitung 7, nämlich an einer Stelle nahe dem Anschluß der Versorgungsleitung 7 an der Versorgungsmittelquelle 3, eine Entlastungseinrichtung 21 für die Versorgungsleitung 7 sowie eine Absperreinrichtung 22 für die Versorgungsleitung 7 vorgesehen sind. Die Entlastungseinrichtung 21 weist einen Entlastungsquerschnitt auf, der ungefähr mit dem Strömungsquerschnitt der Versorgungsleitung 7 übereinstimmt, so daß eine sehr schnelle, wirksame Entlastung nach rückwärts erfolgen kann. Im konkret dargestellten Ausführungsbeispiel kann beispielsweise die Versorgungsleitung 7 einen Durchmesser von 42 mm aufweisen, also einen Strömungsquerschnitt von ca. 1.330 mm². Diesen Querschnitt hätte dann auch die Entlastungseinrichtung 21. Bei einer Versorgungsleitung mit einer Länge von 400 m braucht so die Entlastung wenige Sekunden, wohl deutlich weniger als 5 sec.. Gleichzeitig kann durch die Absperreinrichtung 22 bei vorgesehener Verriegelung von Entlastungseinrichtung 21 und Absperreinrichtung 22 dafür gesorgt werden, daß von der Versorgungsmittelquelle 3 kein weiteres Versorgungsmittel nachströmt.

Hinsichtlich der Entlastungseinrichtung 21 und der Absperreinrichtung 22 zeigt die Darstellung in Fig. 1 beide nur schematisch als Absperrorgane. Solche Absperrorgane sind im Stand der Technik Kugelhahnventile, Schieber od. dgl..

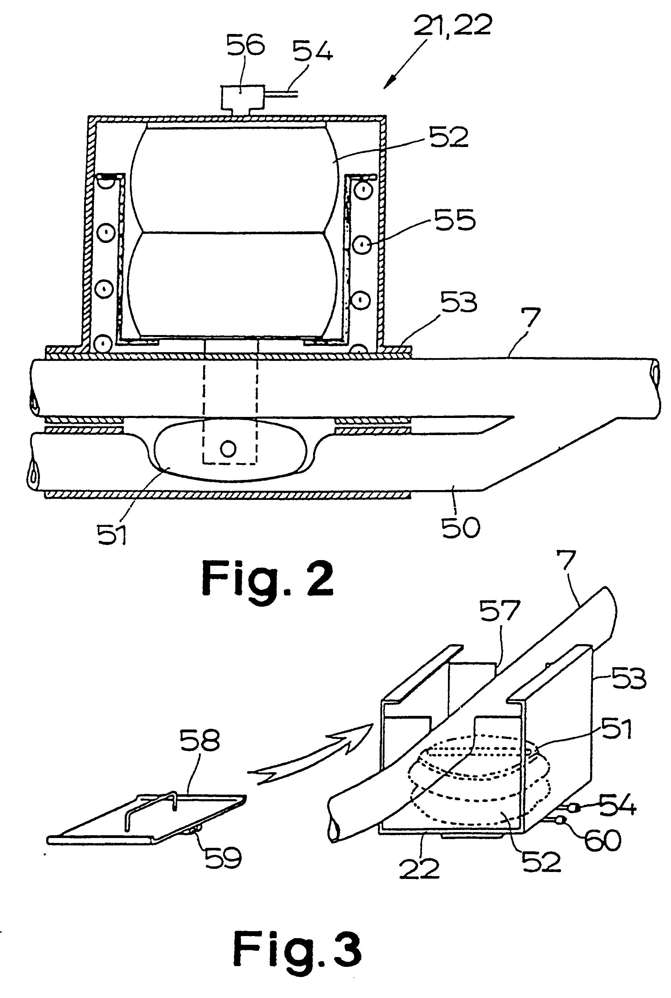

Die Fig. 2, 3 und 4 zeigen nun besonders bevorzugte, weil nämlich besonders einfache und robuste Ausführungsformen einer Entlastungseinrichtung 21 für die Versorgungsleitung 7 bzw. einer Absperreinrichtung 22. Die hier dargestellten Ausführungsbeispiele erfordern es, daß die Versorgungsleitung 7 zumindest im Bereich der Entlastungseinrichtung 21 und/oder der Absperreinrichtung 22 zusammenquetschbar ist. Dies gilt einerseits für die Versorgungsleitung 7 selbst, andererseits für einen durch die Entlastungseinrichtung 21 geführten Entlastungsstutzen 50. In allen Fällen gilt, daß hier die Entlastungseinrichtung 21 und/oder die Absperreinrichtung 22 ein bzw. jeweils ein bewegbares Quetschelement 51 zum Zusammenquetschen der entsprechenden Versorgungsleitung 7 bzw. des Entlastungsstutzens 50 aufweisen. In den hier dargestellten und bevorzugten Ausführungsbeispielen ist dabei das Quetschelement 51 von einem pneumatischen oder hydraulischen Antrieb, insbesondere einem Balgzylinder 52 bewegbar.

Das in Fig. 2 zunächst dargestellte, insoweit bevorzugte Ausführungsbeispiel weist nebeneinander, parallel zueinander verlaufende Versorgungsleitungen 7 und Entlastungsstutzen 50 auf. In einem Gehäuse 53, das die Entlastungseinrichtung 21, die Absperreinrichtung 22, die Versorgungsleitung 7 in diesem Bereich, den Entlastungsstutzen 50 in diesem Bereich und das Quetschelement 51 umgibt, ist ein Quetschelement 51 zwischen der Versorgungsleitung 7 und dem Entlastungsstutzen 50 angeordnet. Durch den hier dargestellten Balgzylinder 52 als Antrieb, der pneumatisch, nämlich über eine Steuerdruckleitung 54 betätigbar ist, kann das Quetschelement 51 entweder in Fig. 2 nach unten zum Öffnen der Versorgungsleitung 7 und Schließen des Entlastungsstutzens 50 oder nach oben zum Entlasten, also Öffnen des Entlastungsstutzen 50 und Schließen der Versorgungsleitung 7 bewegt werden. Der Antrieb ist also doppeltwirkend. Das wird im hier dargestellten und bevorzugten Ausführungsbeispiel dadurch erreicht, daß entgegen der Wirkungseinrichtung des Balgzylinders 52 eine als Schraubendruckfeder ausgeführte Feder 55 vorgesehen ist, die den Balgzylinder 52 normalerweise zusammenzudrücken versucht und das Quetschelement 51 in der hier dargestellten Konstruktion in Richtung des Entlastungszustands bewegt. Nur bei mit Druck beaufschlagtem Balgzylinder 52 ist also hier die Versorgungsleitung 7 geöffnet und der Entlastungsstutzen 50 geschlossen, fällt der Steuerdruck ab, so drückt die Feder 55 den Balgzylinder 52 in Fig. 2 nach oben zusammen und quetscht so die Versorgungsleitung 7 zusammen.

Fig. 1 zeigt in dem zuvor erläuterten Zusammenhang, daß die Steuerdruckleitung 54 für die Entlastungseinrichtung 21 und die Absperreinrichtung 22 ohne weiteres an einen gemeinsamen Drucklufterzeuger angeschlossen sein kann, an den auch beispielsweise die der Versorgungsmittelquelle 3 zugeordnete Druckluftleitung 1 angeschlossen ist. Zur gezielten Steuerung des Balgzylinders 52 zeigt dabei Fig. 2 noch ein Steuerventil 56 an der Steuerdruckleitung 54, das im hier dargestellten Ausführungsbeispiel als einfaches 3/2-Ventil ausgeführt werden kann.

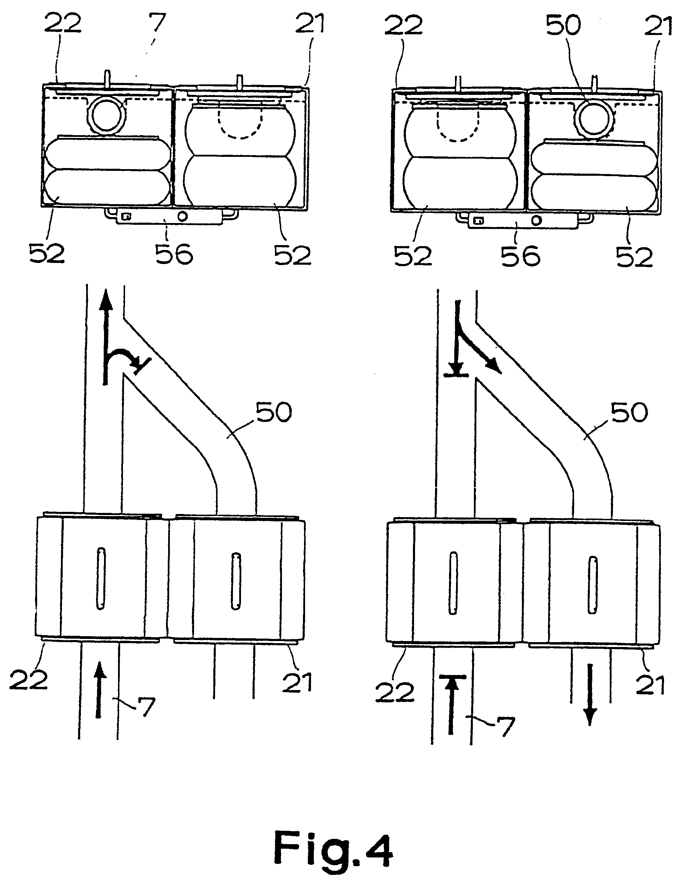

Das in den Fig. 3 und 4 dargestellte, weitere Ausführungsbeispiel der zuvor grundsätzlich erläuterten Lehre der Erfindung weist zunächst ebenfalls ein Quetschelement 51 und einen Balgzylinder 52 als pneumatischen Antrieb auf. Dieses Ausführungsbeispiel, erläutert anhand von Fig. 3 für die Absperreinrichtung 22 der Versorgungsleitung 7, zeichnet sich durch besondere Einfachheit und hervorragende Nachrüstbarkeit an bestehenden Versorgungsleitungen 7 aus. Das Gehäuse 53 ist hier kastenartig mit Seitenwänden und Stirnwänden ausgeführt, wobei die Stirnwände am oberen Rand jeweils etwa U-förmige Ausnehmungen zur Aufnahme der Versorgungsleitung 7 aufweisen. In diese Ausnehmungen 57 kann die Versorgungsleitung 7 von oben eingelegt werden. Wie Fig. 3 zeigt, wird dann das Gehäuse 53 durch einen einschiebbaren Deckel 58 geschlossen, der durch nach innen gebogene Halteflansche am Gehäuse 53 in eingeschobener Stellung darin gehindert wird, nach oben vom Gehäuse 53 abzuheben. Dem Quetschelement 51 auf dem Balgzylinder 52, das hier als quer zur Versorgungsleitung 7 angeordnete Quetschleiste ausgeführt ist, ist auf der Innenseite des Deckels 58 ein korrespondierendes Quetschelement 59 zugeordnet. Wird im Betrieb bei eingelegter Versorgungsleitung 7 Druckluft über die auch hier vorhandene Steuerdruckleitung 54 auf den Balgzylinder 52 gegeben, so dehnt sich dieser aus, hebt das Quetschelement 51 nach oben an und quetscht so die Versorgungsleitung 7 zwischen den Quetschelementen 51 und 59 zusammen. Dargestellt ist im übrigen auch noch eine Druckentlastungsleitung 60 für den Balgzylinder 52. An die Leitungen 54, 60 kann ein hier nicht dargestelltes Steuerventil, beispielsweise ein 4/2-Steuerventil angeschlossen werden.

Fig. 4 zeigt nun in einer ohne weiteres verständlichen Darstellung das Zusammenwirken einer Entlastungseinrichtung 21 und einer Absperreinrichtung 22, beide nach dem System von Fig. 3 aufgebaut. Die beiden Balgzylinder 52, die auch im hier dargestellten Ausführungsbeispiel den Antrieb für die Quetschelemente 51 bilden, sind über ein Steuerventil 56, das hier als 5/2-Wegeventil ausgeführt ist, mit einer nicht dargestellten Steuerdruckleitung und miteinander verbunden, so daß bei einem 1/0-Signal stets einer der beiden Balgzylinder 52 ausgefahren und der andere der beiden Balgzylinder 52 zusammengezogen ist. Die linke Hälfte von Fig. 4 zeigt den normalen Betriebszustand mit offener Versorgungsleitung 7 und zusammengequetschtem Entlastungsstutzen 50, wobei in Fig. 4 links unten die Strömungsrichtung dargestellt ist. In der rechten Hälfte von Fig. 4 ist dann die Entlastungsstellung gezeigt mit zusammengequetschter Versorgungsleitung 7 und geöffnetem Entlastungsstutzen 50, rechts unten wieder die Strömungsrichtungen. Diese Technik ist ganz besonders zweckmäßig und ohne weiteres an einem bestehenden System nachrüstbar. Die Ausführung der Antriebe als Balgzylinder 52 ist robust und weitestgehend wartungsfrei, zumal die Balgzylinder 52 im vorliegenden Ausführungsbeispiel auch noch durch die Gehäuse 53 gegen Beschädigungen geschützt sind. Die pneumatische Steuerung von der Druckluftquelle her über die Steuerdruckleitung ist systemtypisch und daher besonders zweckmäßig.

## Ansprüche

1. Sicherheitseinrichtung (9) für ein von einer Bedienungsperson zu handhabendes Gerät (8), das über eine Versorgungsleitung (7) für ein Versorgungsmittel an eine Versorgungsmittelquelle (3) angeschlossen ist, mit einer Steuereinrichtung (10) zur Steuerung der Funktion des Gerätes (8) und mit einer Entlastungseinrichtung (21) für die Versorgungsleitung (7), wobei die Entlastungseinrichtung (21) an einer vom Gerät (8) entfernten Stelle der Versorgungsleitung (7), insbesondere an einer Stelle nahe dem Anschluß der Versorgungsleitung (7) an der Versorgungsmittelquelle (3), angeordnet ist, wobei die Entlastungseinrichtung (21) für die Versorgungsleitung (7) einen Entlastungsquerschnitt aufweist, der ungefähr mit dem Strömungsquerschnitt der Versorgungsleitung (7) übereinstimmt und wobei der Entlastungseinrichtung (21) für die Versorgungsleitung (7) eine Absperreinrichtung (22) zugeordnet ist und, insbesondere, die Entlastungseinrichtung (21) und die Absperreinrichtung (22) gegeneinander verriegelt sind, **dadurch gekennzeichnet,** daß die Versorgungsleitung (7) im Bereich der Entlastungseinrichtung (21) und der Absperreinrichtung (22) zusammenquetschbar ist und dazu in diesem Bereich ein kastenartiges, mit Ausnehmungen (57) zur Aufnahme der Versorgungsleitung (7) und ggf. eines Entlastungsstutzens (50) versehenes Gehäuse (53) und einen das Gehäuse (53) verschliessenden Deckel (58) aufweist sowie ein bzw. jeweils ein bewegbares Quetschelement (51) aufweist, daß das bewegbare Quetschelement (51) bzw. jedes bewegbare Quetschelement (51) von einem Balgzylinder (52) bewegbar ist und daß dem bewegbaren Quetschelement (51) bzw. jedem bewegbaren Quetschelement (51) im Gehäuse (53) ein feststehendes bzw. jeweils ein feststehendes Quetschelement (59) zugeordnet ist.

2. Sicherheitseinrichtung nach Anspruch 1, dadurch gekennzeichnet, daß durch die Entlastungseinrichtung (21) ein parallel zur Versorgungsleitung (7) verlaufender Entlastungsstutzen (50) geführt ist, daß das Gehäuse (53) die Entlastungseinrichtung (21), die Absperreinrichtung (22), die Versorgungsleitung (7) auf einem Stück, den Entlastungsstutzen (50) auf einem Stück und das Quetschelement (51) umgibt, daß nur ein Quetschelement (51) vorhanden und zwischen der Versorgungsleitung (7) und dem Entlastungsstutzen (50) angeordnet ist und daß das eine Quetschelement (51) durch den Balgzylinder (52) entweder in eine Richtung zum Öffnen der Versorgungsleitung (7) und Schließen des Entlastungsstutzens (50) oder in der anderen Richtung zum Öffnen des Entlastungsstutzens (50) und Schließen der Versorgungsleitung (7) bewegbar ist.

3. Sicherheitseinrichtung nach Anspruch 2, dadurch gekennzeichnet, daß eine entgegen der Wirkungsrichtung des Balgzylinders (52) wirkende Feder (55) vorgesehen ist, die den Balgzylinder (52) normalerweise zusammenzudrücken versucht und das Quetschelement (51) in einer Richtung, vorzugsweise in Richtung des Entlastungszustands, vorspannt.

4. Sicherheitseinrichtung nach Anspruch 1, dadurch gekennzeichnet, daß die Entlastungseinrichtung (21) und die Absperreinrichtung (22) jeweils einen Balgzylinder (52), der auf ein entsprechendes Quetschelement (51) wirkt, aufweisen, daß beide Balgzylinder (52) über ein gemeinsames Steuerventil (56) mit einer Steuerdruckleitung und miteinander verbunden sind und daß bei einem Steuersignal stets einer der Balgzylinder (52) ausgefahren und der andere Balgzylinder (52) zusammengezogen ist.

5. Sicherheitseinrichtung nach einem der Ansprüche 1 bis 4, dadurch gekennzeichnet, daß der Deckel (58) in das Gehäuse (53) einschiebbar ist und daß, vorzugsweise, das Gehäuse (53) kastenartig mit Seitenwänden und Stirnwänden ausgeführt ist, wobei die Stirnwände am oberen Rand jeweils etwa U-förmige Ausnehmungen zur Aufnahme der Versorgungsleitung (7) (bzw. des Entlastungsstutzens (50)) aufweisen, der Balgzylinder (52) unterhalb der U-förmigen Ausnehmungen im Gehäuse (53) sitzt und an seiner Oberseite das als Quetschleiste ausgeführte Quetschelement (51) aufweist und im Betrieb bei eingelegter Versorgungsleitung (7) das Quetschelement (51) durch den sich ausdehnenden Balgzylinder (52) nach oben angehoben wird.

6. Sicherheitseinrichtung nach einem der Ansprüche 1 bis 5, dadurch gekennzeichnet, daß das feststehende Quetschelement (59) an der Innenseite des Deckels (58) angeordnet ist.

## Claims

1. Safety device (9) for an apparatus (8) which is to be used by an operator (30) and which is connected to a supply (3) for supply means via a supply line (7), comprising a control device (10) for control of the operation of the apparatus (8) and comprising a relief device (21) for the supply line (7),
   wherein the relief device (21) is provided for at a position in the supply line (7) far away from the apparatus (8), preferably at a position in the supply line (7) in the vicinity of the connection of the supply line (7) to the supply (3),
   wherein the relief device (21) for the supply line (7) has a relief cross section approximately corresponding to the flow cross section of the supply line (7), and
   wherein a shut-off device (22) for the supply line (7) is associated with the relief device (21) for the supply line (7) and, preferably, the relief device (21) and the shut-off device (22) are interlocked with each other, **characterized in that**
   the supply line (7) is compressible in the relief device (21) and the shut-off device (22),
   that in this area a housing (53) is positioned which is made in the shape of a box having recesses (57) for receiving the supply line (7) and, if provided for, a relief connector (50), that a lid (58) closing the housing (53) as well as at least one movable compression element (51) is provided,
   that the movable compression element (51) or each movable compression element (51) is movable by means of a bellows cylinder (52), and that with the movable compression element (51) or each movable compression element (51) in housing (53) a corresponding fixed compression element (59) or each a corresponding fixed compression element (59) is associated.

2. Safety device (9) according to claim (1), characterized in that a relief connector (50) is positioned in the relief device (21) in parallel to the supply line (7), that the housing (53) surrounds the relief device (21), the shut-off device (22), the supply line (7) in this area and the compression element (51),
   that only one compression element (51) is provided here which is positioned between the supply line (7) and the relief connector (50), and that the one compression element (51) by means of the propulsion by the bellows cylinder (52) can either be moved in one direction to open the supply line (7) and to close the relief connector (50) or in the opposite direction to open the relief connector (50) and to close the supply line (7).

3. Safety device according to claim 2, characterized in that a spring (55) operating in opposition to the direction of action of the bellows cylinder (52) is provided which normally tries to compress the bellows cylinder (52) and moves the compression element (51) into one direction, preferably in the direction of the state of relief.

4. Safety device according to claim 1, characterized in that the relief device (21) and the shut-off device (22) each comprise their own bellows cylinder (52) moving the corresponding compression element (51), that both bellows cylinders (52) are connected to each other and to a control pressure line via a common control valve (56), and that in case of a control signal one of the two bellows cylinders (52) is always extended and the other of the two bellows cylinders (52) is always compressed.

5. Safety device (9) according to any of claims 1 through 4, characterized in that the lid (58) may be slidingly inserted into the housing (53) and that, preferably, the housing (53) is made in the shape of a box with lateral walls and front and back walls, the front and back walls each having approximately U-shaped recesses on their upper edges for receiving the supply line (7) (or the relief connector (50) respectively), the bellows cylinder (52) being positioned below the recesses in the housing (53) and being provided with a compression strip on its top side as a compression element (51), and that in operation with the supply line (7) inserted the compression element (51) is lifted upwardly by means of the expanding bellows cylinder (52).

6. Safety device (9) according to any of the claims 1 through 5, characterized in that the fixed compression element (59) is positioned on the inside of the lid (58).

## Revendications

1. Mécanisme de sécurité (9) pour un appareil (8) destiné à être manipulé par une personne préposée à la manoeuvre, qui est raccordé à une source (3) d'agent d'alimentation par l'intermédiaire d'une conduite d'alimentation (7) destinée à un agent d'alimentation, muni d'un mécanisme de commande (10) destiné à la commande de la mise en service de l'appareil (8) et d'un mécanisme de décharge (21) destiné à la canalisation d'alimentation (7), le mécanisme de décharge (21) étant disposé à un endroit de la canalisation d'alimentation (7) éloigné de l'appareil (8), en particulier, à un endroit proche du raccordement de la canalisation d'alimentation (7) à la source d'agent d'alimentation (3), le mécanisme de décharge (21) destiné à la canalisation d'alimentation (7) présentant une section transversale de décharge qui correspond approximativement à la section transversale d'écoulement de la canalisation d'alimentation (7) et dans lequel, au mécanisme de décharge (21) destiné à la canalisation d'alimentation (7), est attribué un mécanisme de blocage (22) et, en particulier, le mécanisme de décharge (21) et le mécanisme de blocage (22) sont verrouillés réciproquement, **caractérisé en ce que** la canalisation d'alimentation (7) peut être comprimée dans la zone du mécanisme de décharge (21) et du mécanisme de blocage (22) et présente à cet effet, dans cette zone, un logement (53) en forme de caisse dans lequel sont pratiqués des évidements (57) pour que viennent s'y loger la canalisation d'alimentation (7) et éventuellement une tubulure de décharge (50), ainsi qu'un couvercle (58) destiné à fermer le logement (53), la canalisation d'alimentation présentant également ou chaque fois un élément mobile de compression (51) ; **en ce que** l'élément mobile de compression (41) ou chaque élément mobile de compression (51) est rendu mobile à l'intervention d'un soufflet cylindrique (52) ; et **en ce que,** à l'élément mobile de compression (51) ou à chaque élément mobile de compression (51) disposé au sein du logement (53), est attribué un élément fixe de compression (59) ou chaque fois un élément fixe de compression (59).

2. Mécanisme de sécurité selon la revendication 1, **caractérisé en ce que,** à travers le mécanisme de décharge (21), est guidée une tubulure de décharge (50) qui s'étend parallèlement à la canalisation d'alimentation (7), **en ce que** le logement (53) entoure le mécanisme de décharge (21), le mécanisme de blocage (22) et la canalisation d'alimentation (7) d'un seul tenant, la tubulure de décharge (50) d'un seul tenant, ainsi que l'élément de compression ; **en ce qu'**un seul élément de compression (51) est présent et est disposé entre la canalisation d'alimentation (7) et la tubulure de décharge (50) et **en ce que** le seul élément de compression (51) est mobile dans un sens pour ouvrir la canalisation d'alimentation (7) et fermer la tubulure de décharge (50) ou dans l'autre sens pour ouvrir la tubulure de décharge (50) et fermer la canalisation d'alimentation (7), par l'intermédiaire du soufflet cylindrique (52).

3. Mécanisme de sécurité selon la revendication 2, **caractérisé en ce** qu'on prévoit un ressort (55) qui agit à l'encontre de la direction d'action du soufflet cylindrique (52) et qui tente normalement de comprimer le soufflet cylindrique (52) et de placer en état de précontrainte l'élément de compression (51) dans un sens, de préférence, dans le sens de l'état de décharge.

4. Mécanisme de sécurité selon la revendication 1, **caractérisé en ce** que le mécanisme de décharge (21) et le mécanisme de blocage (22) présentent, respectivement, un soufflet cylindrique (52) qui agit sur un élément de compression correspondant (51), **en ce que** les deux soufflets cylindriques (52) sont reliés l'un à l'autre, ainsi qu'à une canalisation de pression de commande, par l'intermédiaire d'une soupape de commande commune (56) et **en ce que,** lors de la réception d'un signal de commande, il y a toujours un des soufflets cylindriques (52) qui se déploie, tandis que l'autre des soufflets cylindriques (52) se comprime.

5. Mécanisme de sécurité selon l'une quelconque des revendications 1 à 4, **caractérisé en ce** qu'on peut faire coulisser le couvercle (58) au sein du logement (53) et **en ce que,** de préférence, le logement (53) est réalisé en forme de caisse et est muni de parois latérales et de parois frontales, les parois frontales présentant, respectivement, au bord supérieur, des évidements approximativement en forme de U pour que vienne s'y loger la canalisation d'alimentation (7) (ou la tubulure de décharge (50)), le soufflet cylindrique (52) logé au sein du logement (53) en dessous des évidements en forme de U, présente, sur son côté supérieur, l'élément de compression (51) réalisé en forme de barre de compression et, lors de la mise en service, après insertion de la canalisation d'alimentation (7), l'élément de compression (51) se soulève vers le haut à l'intervention du soufflet cylindrique (52) qui se dilate.

6. Mécanisme de sécurité selon l'une quelconque des revendications 1 à 5, **caractérisé en ce** que l'élément fixe de compression (59) est disposé sur la face interne du couvercle (58).

**Fig. 1**

EP 0 299 541 B1

**Fig. 2**

**Fig.3**

# Fig.4